Europäisches Patentamt

European Patent Office

Office européen des brevets

(19)

(11) Publication number: **0 127 861 B1**

# (12) EUROPEAN PATENT SPECIFICATION

(45) Date of publication of patent specification: **18.09.91**  (51) Int. Cl.⁵: **G03F 7/20**

(21) Application number: **84106027.0**

(22) Date of filing: **26.05.84**

(54) X-ray lithography.

(30) Priority: **06.06.83 US 501600**

(43) Date of publication of application:
**12.12.84 Bulletin 84/50**

(45) Publication of the grant of the patent:
**18.09.91 Bulletin 91/38**

(84) Designated Contracting States:
**AT BE CH DE FR GB IT LI NL SE**

(56) References cited:
**DE-A- 2 302 398**
**DE-A- 2 740 366**
**US-A- 4 346 314**

**PROCEEDINGS OF THE SYMPOSIUM ON
ELECTRON AND ION BEAM SCIENCE AND
TECHNOLOGY EIGHTH INTERNATIONAL
CONFERENCE 1978, Princeton, New York, US,
pages 432-443, vol. 78-5; M.C. PECKERAR et
al.: "High speed x-ray lithography with radiation from laser-produced plasmas"**

**ELECTRONICS LETTERS, vol. 14, no.24, 23rd
November 1978, pages 781,782; D.J. NAGEL
et al.: "Submicrosecond x-ray lithography"**

(73) Proprietor: **THE UNIVERSITY OF ROCHESTER
Office of Research and Project Administra-
tion, 30 Administration Building
Rochester, New York 14627(US)**

(72) Inventor: **Yaakobi, Barukh
50 Dunrovin Lane
Rochester New York 14618(US)**

(74) Representative: **Wagner, Karl H.
WAGNER & GEYER Patentanwälte Gewürz-
mühlstrasse 5 Postfach 246
W-8000 München 22(DE)**

IEEE INTERNATIONAL CONFERENCE ON CIR-
CUITS AND COMPUTERS, ICCC80, Port Ches-
ter, New York, US, 1st-3rd October 1980,
pages 543-547, IEEE, New York, US; H. BETZ
et al.: "Present status and problems of x-ray
lithography"

IBM TECHNICAL DISCLOSURE BULLETIN, vol.
14, no. 7, December 1971, page 2104, New
York, US; N.J. CLECAK et al.: "Photoresist
exposure process"

SOVIET PHYSICS TECHNICAL PHYSICS, vol.
27, no. 3, March 1982, pages 346,347, Ameri-
can Institute of Physics, New York, US; Yu.S.
BOKOV et al.: "Conditions for using a laser-
stimulated x-ray source in contact lithog-
raphy"

PATENTS ABSTRACTS OF JAPAN, vol. 5, no.
186 (E-84)[858], 25th November 1981; & JP-
A-56 111 223 (CHO LSI GIJUTSU KENKYU
KUMIAI) 02-09-1981

APPLIED PHYSICS LETTERS, vol. 43, no. 7,
1st October 1983, pages 686-688, American
Institute of Physics, New York, US; B.
YAAKOBI et al.: "Submicron x-ray lithog-
raphy using laser-produced plasma as a
source"

## Description

The present invention relates to x-ray lithography, and particularly to submicron x-ray lithography using an ultraviolet, laser produced plasma as a source of x-rays.

The present invention is especially suitable for use in producing high-resolution, submicron patterns in resist material for use in constructing integrated circuits. The invention also has application wherever high resolution, submicron patterns are needed, which photolithography is incapable of producing.

X-ray lithography has been proposed wherein the x-rays are generated by the interaction of an electron beam and a metal target (see U.S. Patent 3,743,842, issued July 3, 1973). The production of pulses of x-rays for lithography using a laser produced plasma has also been suggested (see U.S. Patent 4,184,078, issued January 15, 1980). Relatively long exposures of the x-ray sensitive material (e.g., x-ray resist) have, however, been required. For example, the system proposed in U.S. Patent 4,184,078 requires the use of 90 laser shots to obtain sufficient absorbed x-ray energy to obtain an acceptable pattern after exposure and developing (see D.J. Nagel, et al., Electronic Letters, 14, 24, p. 781 (1978)). The minimum exposure which has been reported is a multi-nanosecond laser shot (a ten nanosecond pulse followed by a one nanosecond pulse) (see P.J. Mallozzi, et al., in Advances in X-ray Analysis (Plenum Press, New York, 1979)).

From the document PROCEEDINGS OF THE SYMPOSIUM ON ELECTRON AND ION BEAM SCIENCE AND TECHNOLOGY EIGTH INTERNATIONAL CONFERENCE 1978, Princeton, New York, US, pages 432-443, Volume 78-5; M.C. PECKERAR et al.: "High speed x-ray lithography with radiation from laser-produced plasmas" it is known that it should be possible to expose polybutene-1-sulfone (PBS) resist with a single shot if the laser, focusing and target parameters are chosen properly. However, no single-shot exposure is demonstrated in said document. US-A-4,346,314 relates to the frequency conversion, particularly tripling of coherent radiation of high intensity laser beams in the red or infra-red.

It has been found, in accordance with the invention that high resolution, submicron x-ray lithography can be carried out using an ultraviolet-laser produced plasma as a source of x-ray pulses. Only a single shot of about one nanosecond (ns) duration of UV laser energy is necessary to produce x-ray flux sufficient for exposure of conventional x-ray resist material. The exposure with the x-ray flux has been carried out with the aid of a shield which blocks the high temperature plasma in the form of debris from the target on which the UV laser pulse is incident. The shield is in thermally coupled relationship with the resist and causes the resist to be heated upon exposure by the x-ray flux. While shields have been used, they have not been used to heat the resist (see U.S. Pat. No. 4,184,078 and the Electronic Letters article, referenced above). The x-ray flux which is incident upon the resist is about an order of magnitude smaller than what has heretofore been required in order to obtain comparable exposures with x-rays from a laser produced plasma. While the invention is not limited to any theory of operation, the increased efficiency of transfer of x-ray energy to the resist enabling the reduction in the required x-ray flux may be due to an abrupt rise in the resist temperature contemporaneous with or after exposure and prior to the development of the resist to produce the pattern.

It is therefore a feature of the present invention to provide an improved method and apparatus for x-ray lithography wherein high resolution submicron patterns may be produced with a minimum of exposure by x-ray energy.

It is another feature of the invention to provide an improved method and apparatus for submicron, high resolution x-ray lithography through the use of conventional x-ray resists and conventional methods of developing such resists after exposure wherein the amount of x-ray energy which is generated is minimized.

It is a still further feature of the invention to provide an improved method of and apparatus for x-ray lithography using laser produced plasma as a source of x-rays, wherein long duration or multiple pulses of laser energy are not required for complete exposure of a pattern for lithographic purposes.

In accordance with one aspect of the present invention a method of x-ray lithography is provided as is claimed in claim 1. In accordance with another aspect of the present invention, an apparatus for laser lithography is provided as is claimed in claim 8. Preferred embodiments of the invention are disclosed in the dependent claims.

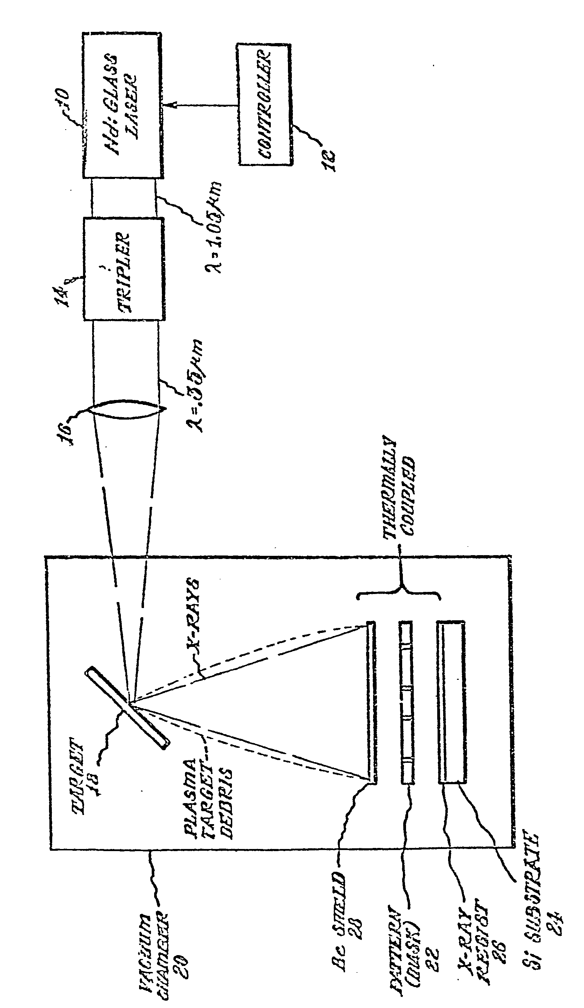

The foregoing and other features, objects and advantages of the invention, as well as the presently preferred embodiment of the invention and the best mode now known for practicing the invention, will be more apparent from a reading of the following description in connection with the accompanying drawing which is a schematic diagram of submicron x-ray lithography apparatus embodying the invention.

Referring more particularly to the drawing, there is shown a frequency tripled Nd:glass laser system using a Nd:glass laser 10. The laser is operated as a mode locked laser by a Pockels cell controller 12 to produce a single pulse of infrared laser light one ns in duration. The wavelength of this light is about 1.05 microns (um). The light emanates from the laser in a beam which passes through a tripler 14 to produce a pulse of output light of approximately 0.35 um in wavelength. The tripler may suitably be of the type described in Patent 4,346,314, issued August 24, 1982 to R.S. Craxton. The one ns pulse of ultraviolet light exits from the tripler 14 in a beam which is focused by a lens 16 to a spot on a flat target 18. In the event that lasers which produce sufficient power in short wavelengths (e.g., the ultraviolet) become available, they may also be used. The light is transmitted through a port in a vacuum chamber 20, which includes the target 14, a mask 22 which defines the pattern, a silicon substrate 24 having a coating 26 of x-ray resist, and a shield 28, suitably of beryllium. The chamber 20 may suitably be evacuated to a pressure of about $10^{-6}$ Torr.

The target is suitably of pure iron. Other metals of high atomic number materials may be used. The target may also be a microballoon containing the target material; for example, a material having a strong emission which matches the sensitivity of the photoresist when converted into a plasma by the laser pulse. The microballoon may be supported on a stalk as in laser fusion apparatus. Then the laser beam may be divided into a plurality (two or more) of beams which can implode the target and produce an intense and very small x-ray source.

The target material is heated by the laser pulse to x-ray emitting temperatures. A small mass of the target, for example, 50 nanograms is converted into a plasma. Most of the absorbed laser energy goes into kinetic energy of the plasma (for example, seventy-three percent). The rest of the energy is converted into the x-ray flux. Suitably, the Nd:glass laser produces a one nanosecond, 35 Joule (J) laser pulse, after frequency tripling. The total x-ray energy emitted by the iron target 18 is then approximately 5.7J. The remainder of the energy is converted into the heated plasma. The x-rays radiate as radial rays from the focal spot on the target onto which the laser pulse is focused by the lens 16. This spot may be approximately 100 um in diameter. The x-rays project towards the shield 28, the pattern 22 and the resist 26. The shield 28, pattern 22 and resist 26 assembly may be positioned at an angle closer to the axis of the laser beam than shown. The inclination of the target 18 may be closer to normal to the laser beam. This alternate arrangement may increase the x-ray flux effective on the resist 26. The plasma or target debris also is projected towards this assembly of shield, pattern and resist. The x-rays are indicated by the lines made up of longer dashes while the plasma/target debris is indicated by the lines made up of short dashes.

Consider the arrangement of the shield 28, mask 22, resist 26 and substrate 24. The resist and the substrate may be supported on a heat-sink, for example, of aluminum. It is not believed that the resist is heated by absorbed x-rays, since the weak exposure can only raise the resist temperature by a few degrees. The resist may be any conventional resist such as PBS (poly butyl sulfide), PMMA (poly methyl methacrylate) or COP (poly glyclycidyl methacrylate-co-ethyl acrylate). After exposure, the resist may be developed by known methods, for example, as described in U.S. Patent 4,215,192 issued July 29, 1980, in the case of COP. The resist properties and development techniques are also discussed in L.F. Thompson, et al., J. Electrochem. Soc.: Solid State Sci. Techn., 121, 1500 (1974) and P.D. Lenzo, et al., Appl. Phys. Lett. 24, 289 (1974).

The mask is suitably a gold grating which is supported along its edges in a frame. The width of the grating lines and their separations may be approximately .45 um. The mask 22 is suitably spaced in close proximity to the surface of the resist 26; a 25 um spacing being suitable. The shield 28 is also in close proximity to the resist 26 so as to be thermally coupled thereto. For example, the resist may be 5 mm from the mask 22. The hot plasma/target debris is blocked by the shield 28 and causes heating thereof. Because the shield is in close proximity and thermally coupled to the resist, the resist is heated. Thermal coupling may occur by radiational coupling and conductive coupling, as through the frame or other support structure for the assembly, which is used but not shown to simplify the drawing. The resist may reach a temperature approximately equal to the glass transition temperature of the polymer constituting the resist 26; for example, a temperature of about 100° C. Heating of the resist occurs soon after the exposure of the resist by the x-rays. This is because the target debris arrives at the shield 28 with a delay of approximately one microsecond, which is long after the exposure has taken place; the x-rays travelling at the speed of light and both the x-rays and the plasma being produced essentially simultaneously at the surface of the target. Other shields may be used, depending upon the transmissivity to x-rays which is desired. The shield 28 passes x-rays above about 1keV. While other materials, such as Mylar also have x-ray transmissive and plasma blocking properties, beryllium is preferred, since it transmits more x-rays for a given plasma blocking capability.

As mentioned above, approximately 27% of the laser energy which is absorbed in the target 18, is converted into x-rays. The efficiency of x-ray production by a UV laser light is high, even though some of the laser energy is lost in the tripler 14. The beryllium shield 22, which is suitably 18 um thick, acts as a filter of the total x-ray energy (5.7J), and approximately .72J is transmitted through the beryllium shield 28. The x-ray energy density incident on the resist 26, which is located 10 cm from the target 20 is approximately 0.57mJ per cm². The total x-ray energy per unit volume absorbed at the surface of the resist is 0.9J per cm³. With conventional x-ray lithography as reported in the above referenced Thompson, et al. and Lenzo, et al. articles, approximately 14J per cm³ of laser energy must be absorbed in the same resist in order to obtain an exposure equivalent to that obtained with the .9J per cm³ energy absorbed in the exemplary apparatus described herein. This is an order of magnitude less x-ray flux (energy) than has heretofore been needed for obtaining a complete exposure. The system is therefore more sensitive by an order of magnitude than systems of x-ray lithography heretofore proposed.

Variations and modifications in the herein described method and apparatus, will undoubtedly suggest themselves to those skilled in the art. In particular, heating of the resist upon or following exposure can be applied by any other method of heating, to any other resist and relating to any other radiation source or particles source used for registering a pattern. Accordingly, the foregoing description should be taken as illustrative and not in a limiting sense.

## Claims

1. A method of x-ray lithography which comprises the steps of generating a single pulse of light having a wavelength in the ultraviolet and a duration not exceeding about one ns, translating said light pulse into a pulse of x-rays, and exposing an x-ray sensitive resist with the x-ray pulse to produce a pattern therein.

2. The method according to claim 1 wherein said translating step is carried out by directing said light pulse to be incident upon a target to produce a plasma of target material which emits said x-ray pulse.

3. The method according to claim 2 wherein a temperature increasing step is provided which comprises the step of placing a shield of material which blocks the plasma-target material, said shield being heated thereby in thermally coupled relationship with said resist.

4. The method according to anyone of claims 1-3 wherein said generating step is carried out by producing a beam of laser light, and said translating step is carried out by placing a target in the path of said laser beam to produce a plasma which emits said x-ray pulse.

5. The method according to claim 4 further comprising focusing said laser beam upon a spot approximately 100 μm on said target.

6. The method according to anyone of claims 1-5 wherein said generating step is carried out by producing a single pulse of infrared laser light and tripling the wavelength of said infrared laser light pulse, and said translating step is carried out by making the tripled laser light pulse incident on a target which faces said resist.

7. The method according to claim 6 wherein said infrared laser light pulse has a wavelength of approximately 1.05 μm and said tripled laser light pulse has a wavelength of approximately 0.35 μm.

8. An apparatus for laser lithography wherein an x-ray mask defining a pattern is positioned in proximity to a substrate having an x-ray sensitive resist material thereon, the improvement comprising means including a laser for producing a single pulse of ultraviolet light having a duration of about 1 ns, a target upon which said laser pulse is incident to produce a plasma from which an x-ray pulse corresponding to said laser pulse is transmitted to expose said resist through said mask.

9. The apparatus according to claim 8 wherein said means including a laser operative in the infrared and a tripler which translates the output of said laser to the ultraviolet.

10. The apparatus according to claim 9 further comprising means for focusing the ultraviolet light from said tripler on the surface of said target to a spot of 100 μm diameter or less.

11. The apparatus as set forth in claim 9 wherein the laser output wavelength is approximately 1.05 μm and the tripler output wavelength is approximately 0.35 μm.

12. The apparatus according to claim 11 wherein the energy of said laser pulse of 0.35 μm is about 35J.

13. The appartus according to claim 9 wherein said resist is selected from PBS, COP, and PMMA.

**14.** The apparatus according to claim 8 where said x-ray pulse presents an energy for absorption by said x-ray resist of approximately 1J per cm³.

**15.** The apparatus according to claim 9 wherein said beam is an x-ray beam resulting from laser target interaction and said heating is carried out by energy from the plasma and target debris from said interaction.

## Revendications

**1.** Procédé de lithographie à rayons X, qui comprend les opérations consistant à produire une impulsion unique de lumière ayant sa longueur d'onde dans l'ultraviolet et d'une durée ne dépassant pas 1 ns environ, à transformer ladite impulsion de lumière en une impulsion de rayons X, et à exposer un agent sensible aux rayons X, du type réserve photographique, à l'impulsion de rayons X afin de produire un motif dans celui-ci.

**2.** Procédé selon la revendication 1, où on effectue ladite opération de transformation en dirigeant ladite impulsion de lumière de façon qu'elle tombe sur une cible et produise un plasma du matériau de la cible qui émet ladite impulsion de rayons X.

**3.** Procédé selon la revendication 2, où une opération d'augmentation de température est prévue qui comprend l'opération consistant à placer un écran de matériau qui arrête le plasma et le matériau de la cible, ledit écran s'échauffant en relation de couplage thermique avec ledit agent sensible.

**4.** Procédé selon l'une quelconque des revendications 1 à 3, où on effectue ladite opération de production en produisant un faisceau de lumière laser, et on effectue ladite opération de transformation en plaçant une cible sur le trajet dudit faisceau laser de façon à produire un plasma qui émet ladite impulsion de rayons X.

**5.** Procédé selon la revendication 4, comprenant en outre l'opération qui consiste à focaliser ledit faisceau laser sur une tache d'environ 100 $\mu$m se trouvant sur ladite cible.

**6.** Procédé selon l'une quelconque des revendications 1 à 5, où on effectue ladite opération de production en produisant une unique impulsion de lumière laser infrarouge et en triplant la longueur d'onde de ladite impulsion de lumière laser infrarouge, et on effectue ladite opération de transformation en faisant que l'impulsion de lumière laser triplée arrive sur une cible qui se trouve en regard dudit agent sensible.

**7.** Procédé selon la revendication 6, où ladite impulsion de lumière laser infrarouge possède une longueur d'onde d'environ 1,05 $\mu$m et ladite impulsion de lumière laser triplée possède une longueur d'onde d'environ 0,35 $\mu$m.

**8.** Appareil de lithographie laser, où un masque pour les rayons X, définissant un motif, est placé à proximité d'un substrat qui porte un matériau sensible aux rayons X, du type réserve photographique, caractérisé en ce qu'il comprend un moyen comportant un laser servant à produire une unique impulsion de lumière ultraviolette d'une durée d'environ 1 ns, une cible sur laquelle ladite impulsion laser arrive afin de produire un plasma à partir duquel une impulsion de rayons X correspondant à ladite impulsion laser est émise afin d'exposer ledit agent sensible au travers dudit masque.

**9.** Appareil selon la revendication 8, où ledit moyen comprend un laser fonctionnant dans l'infrarouge et un tripleur qui transforme le signal de sortie laser en lumière ultraviolette.

**10.** Appareil selon la revendication 9, comprenant en outre un moyen qui sert à focaliser la lumière ultraviolette venant dudit tripleur sur la surface de ladite cible en une tache d'un diamètre de 100 $\mu$m ou moins.

**11.** Appareil selon la revendication 9, où la longueur d'onde de sortie du laser est d'environ 1,05 $\mu$m et la longueur de sortie du tripleur est d'environ 0,35 $\mu$m.

**12.** Appareil selon la revendication 11, où l'énergie de l'impulsion laser de 0,35 $\mu$m est d'environ 35 J.

**13.** Appareil selon la revendication 9, où ledit agent sensible de type réserve photographique est sélectionné parmi PBS, COP et PMMA.

**14.** Appareil selon la revendication 8, où ladite impulsion de rayons X présente une énergie permettant une absorption par ledit agent sensible aux rayons X d'environ 1 $J.cm^{-3}$.

**15.** Appareil selon la revendication 9, où ledit faisceau est un faisceau de rayons X résultant de l'interaction laser-cible et ledit échauffement est effectué par l'énergie provenant du plasma et des débris de cible issus de ladite interaction.

## Patentansprüche

1. Verfahren zur Röntgenstrahllitographie, welches folgende Schritte aufweist:
Erzeugung eines einzigen Lichtimpulses mit einer Wellenlänge im ultravioletten und einer ungefähr eine ns nicht übersteigenden Dauer, Umwandlung des Lichtimpulses in einen Impuls von Röntgenstrahlen, und
Belichten eines röntgenstrahlempfindlichen Resistmaterials mit dem Röntgenstrahlimpuls zur Erzeugung eines Musters darinnen.

2. Verfahren nach Anspruch 1, wobei der Umwandlungsschritt ausgeführt wird durch Leiten des Lichtimpulses zum Auftreffen auf ein Target zur Erzeugung eines Plasmas aus Targetmaterial, welches den Röntgenstrahlimpuls imitiert.

3. Verfahren nach Anspruch 2, wobei ein Schritt der Temperaturerhöhung vorgesehen ist, der den Schritt der Anordnung einer Materialabschirmung umfaßt, die das Plasmatargetmaterial blockiert, wobei der Schirm dadurch in thermisch gekoppelter Beziehung mit dem Resistmaterial erhitzt wird. .

4. Verfahren nach einem der Ansprüche 1 bis 3, wobei der Erzeugungsschritt ausgeführt wird durch Erzeugung eines Laserlichtstrahls, und wobei der Umwandlungsschritt ausgeführt wird durch Anordnung eines Targets in der Bahn des Laserlichtstrahls zur Erzeugung eines Plasmas, welches den Röntgenstrahlimpuls imitiert.

5. Verfahren nach Anspruch 4, wobei ferner das Fokussieren des Laserstrahls auf einen Punkt von annähernd 100 μm auf den Target vorgesehen ist.

6. Verfahren nach einem der Ansprüche 1 bis 5, wobei der Erzeugungsschritt ausgeführt wird durch Erzeugung eines einzigen Infrarotlaserlichtimpulses und Verdreifachung der Wellenlänge des Infrarotlaserlichtimpulses und wobei der Umwandlungsschritt ausgeführt wird dadurch, daß man den verdreifachten Laserlichtimpuls auf ein Target zum Auftreffen bringt, welches zu dem Resistmaterial hinweist.

7. Verfahren nach Anspruch 6, wobei der Infrarotlaserlichtimpuls eine Wellenlänge von annä-

hernd 1,05 μm besitzt und der verdreifachte Laserlichtimpuls eine Wellenlänge von annähernd 0,35 μm besitzt.

8. Vorrichtung zur Laserlithographie, wobei eine ein Muster definierende Röntgenstrahlmaske in der Nähe eines Substrates mit einem röntgenstrahlempfindlichen Resistmaterial darauf positioniert wird, dadurch gekennzeichnet, daß Mittel vorgesehen sind, welche einen Laser aufweisen zur Erzeugung eines Einzelimpulses aus ultraviolettem Licht mit einer Dauer von ungefähr ein ns, ein Target auf den der Laserimpuls auftrifft, um ein Plasma zu erzeugen, aus dem ein Röntgenstrahlimpuls entsprechend dem Laserimpuls zur Belichtung des Resistmaterial durch die Maske übertragen wird.

9. Vorrichtung nach Anspruch 8, wobei die Mittel einen Laser aufweisen, der im infraroten betrieben wird, und wobei Verdreifachungsmittel vorgesehen sind, welche die Ausgangsgröße des Lasers ins Ultraviolette übertragen.

10. Vorrichtung nach Anspruch 9, wobei ferner Mittel vorgesehen sind zur Fokussierung des ultravioletten Lichtes von den Verdreifachungsmitteln auf der Oberfläche des Targets auf einen Punkt von 100 μm Durchmesser oder weniger.

11. Vorrichtung nach Anspruch 9, wobei die Laserausgangswellenlänge annähernd 1,05 μm ist und die Ausgangswellenlänge der Verdreifachungsmittel annähernd 0,35 μm beträgt.

12. Vorrichtung nach Anspruch 11, wobei die Energie des Laserimpulses von 0,35 μm ungefähr 35 J beträgt.

13. Vorrichtung nach Anspruch 9, wobei das Resistmaterial ausgewählt ist aus PBS, COP und PMMA.

14. Vorrichtung nach Anspruch 8, wobei der Röntgenstrahlimpuls eine Energie zur Absorbtion durch das Röntgenstrahlresistmaterial von annähernd 1 J pro $cm^3$ aufweist.

15. Vorrichtung nach Anspruch 9, wobei der Strähl ein Röntgenstrahl ist, und zwar sich ergebend aus der Lasertargetwechselwirkung, und wobei ferner die Erwärmung ausgeführt wird durch Energie des Plasmas und des Targetabfalls aus der erwähnten Wechselwirkung.

TARGET
18

VACUUM
CHAMBER
20

PLASMA
TARGET
DEBRIS

X-RAYS

Be SHIELD
28

PATTERN
(MASK)
22

X-RAY
REGIST
26

Si SUBSTRATE
24

THERMALLY
COUPLED

16

$\lambda = .35 \mu m$

14

TRIPLER

$\lambda = 1.05 \mu m$

10

Nd: GLASS
LASER

CONTROLLER

12

EP 0 127 861 B1

8